# EUROPEAN PATENT SPECIFICATION

(11) **EP 0 594 266 B1**
(45) Date of publication and mention of the grant of the patent: **20.08.1997**
(21) Application number: 93203384.8
(22) Date of filing: 17.05.1989
(51) Int. Cl.: G11C 11/419, G11C 7/00

(54) **SRAM with flash clear for selectable I/Os**
SRAM mit Flash-Rücksetzung für auswählbare E/A-Leitungen
SRAM avec une remise simultanée à l'état de départ pour des lignes d'entrée et de sortie sélectionnées

(30) Priority: 18.05.1988 US 195696
(43) Date of publication of application: 27.04.1994
(62) Divisional of application: 89401362.2
(73) Proprietor: SGS-THOMSON MICROELECTRONICS, INC., Carrollton Texas 75006 (US)
(72) Inventor: McClure, David Charles, Cabinet BALLOT-SCHMIT, F-75116 Paris (FR); Lysinger, Mark A.,, Texas 75007 (US)
(74) Representative: Driver, Virginia Rozanne

(56) References cited:
- EP-A- 0 189 700
- EP-A- 0 237 813

## Description

The present invention pertains in general to memories, and more particularly, to a multiple I/O SRAM having the capability of clearing selected memory cells.

The cache memory market is growing at a rapid pace with the advent of the high-performance 32-bit microprocessors. The cache memory is a small but fast memory block typically inserted between the CPU and the primary memory. The CPU fetches data and instructions from the cache when it is determined that the desired data and instructions reside in the cache. Since the cache memory is about ten times faster than the primary memory, the CPU-memory speed gap is considerably reduced when accessing the cache.

In the cache memory scheme, the primary memory and the cache memory are usually divided into equal-size pages. Required pages from the primary memory are first transferred into the cache and execution of the program begins with the CPU fetching data and instructions from the cache. If the address of the instruction to be executed or the data to be fetched is not in the cache memory (i.e., a miss), an appropriate page from the primary memory is transferred into the cache memory. If the address is in the cache memory (i.e., a hit), the execution of instructions from the cache continues. One method for writing data into a primary memory location using a cache scheme requires a tag to be associated with each cache page. The tag indicates whether a page is altered or not due to a memory Write operation. If not altered, the page is discarded and another required page is brought into the cache. Some type of virtual memory management scheme is required to manage the cache-primary memory instructions.

Since the cache memory compares each address generated by the microprocessor with the tag to determine if there is a hit, it is important that the integrity of this tag be maintained such that an invalid hit does not occur. An invalid hit can occur, for example, upon power up of the system since a random sequence of bits is initially stored in the tag. To determine the validity of the tags, one bit in each of the tags is designated as a valid bit. The I/O associated with this valid bit is typically tied to a positive voltage representing the logic high voltage which, when written to the valid bit, provides an indication of a valid tag. Initially, the entire memory is flash cleared such that all zeroes are stored in each of the tag bits until a tag is stored in the address cache, at which time the logic "1" is written in the valid bit for the tag written to. By determining whether the valid bit for the addressed tag is a logic "1", the presence of a hit can be determined.

In prior systems, the memory utilized for both the address cache and the data cache in the cache system utilized static random access memories (SRAM's). The entire memory was cleared upon power up of the system by storing a zero in each of the memory locations by various methods. One method required sequentially addressing all of the memory locations and forcing a zero therein. Another system forces all of the memory locations to zero. One disadvantage to this latter system is that drivers must be present which can drive all of the memory locations to a "0" logic state. In addition, some type of interconnection is required for each of the memory cells which increases the amount of space occupied by the memory array. Typically, each column of memory cells will require a separate run of conductive material to interface with each of the memory cells for the clear function. The drive requirements for clearing all of the memory cells results in relatively large drive transistors. In any event, it is not necessary to clear the entire memory since only one bit determines whether there is valid tag information in a cache memory. There therefor exists a need for a more versatile memory that allows clearing of less than all of the memory cells.

EP-0259967 describes a semiconductor memory device having a main memory and a cache memory. A validity unit of the device is provided for storing validity bits for indicating a valid/invalid state of address data in each address of the memory unit, and an initialize circuit is arranged to simultaneously invalidate the valid bits.

EP-0257938 describes a digital memory having a column activation means for applying either a reset signal or a preset signal to the columns of a memory matrix to individually reset or preset a particular column.

EP-0189700 describes a static RAM having a flash clear function. The RAM has a flip-flop cell and employs a circuit for simultaneously clearing all cells to a logic zero. A flash clear signal is applied to a flash clear line, which can be shared by adjacent cells bordering the line.

The present application is a divisional Application from European Application No. 89401362.2 (EP-A- 0 343 068) which describes and claims a memory with selectively clearable memory cells comprising:
an array of memory cells arranged in rows and columns including memory cells operable to store a first or a second logic state therein and having a flash clear input for forcing the logic state stored therein to said first logic state in response to receiving a flash clear signal, the flash clear inputs for said memory cells in a given one of said columns being commonly connected together;
row address decode means for receiving and decoding a row address and accessing an associated one of said rows of memory cells in said array;
input/output means for interfacing with the accessed ones of said memory cells for inputting data thereto for a write operation and outputting data therefrom for a read operation, wherein memory cells in pairs of adjacent columns have their commonly connected flash clear inputs connected to flash clear means including a first common conductive run disposed adjacent the columns in each pair, said first common conductive run being arranged to receive a flash clear signal for connection to the commonly connected flash clear inputs of the associated ones of said memory cells for clearing thereof in response to said clear signal,
characterised in that said columns of memory cells are configured such that a given column address is associated with a group of said columns of memory cells, there being column address decode means operable to select the group of said columns of memory cells associated with a received column address, each of said columns of memory cells in each group being associated with a separate data bit in a bit sequence, each pair of adjacent columns including columns associated with the same data bit of separate column addresses wherein said flash clear means is operable to connect the flash clear signal to the commonly connected flash clear inputs of memory cells in selected pairs such that memory cells in columns of the selected pairs containing the same data bit of different bit sequences are forced to said first logic state.

That Application also claims a method for selectively clearing memory cells in a multiple input/output memory, comprising:
disposing memory cells in an array in rows and columns;
connecting memory cells in pairs of adjacent columns to a first common conductive run disposed adjacent the columns in each pair;
connecting a flash clear signal to first common conductive run of pairs of adjacent columns to be flash cleared,
characterised in that said columns of memory cells are configured such that a given column address is associated with a group of said columns of memory cells, each of said columns of memory cells in each group associated with a separate data bit in a bit sequence and wherein each pair of adjacent columns includes columns associated with the same data bit of separate column addresses, wherein said flash clear signal is connected to the memory cells in selected pairs such that memory cells in columns of the selected pairs containing the same data bit of different bit sequences are forced to a first logic state.

According to the present invention there is provided a memory array with selectively clearable memory cells, comprising:
an array of selectively addressable SRAM cells arranged in rows and columns, including memory cells operable to store first and second logic states therein, and having a flash clear input for forcing the logic state stored therein to the first logic state in response to receiving a flash clear signal at the flash clear input;
a plurality of common conductive runs connected to the flash clear inputs of cells in respective columns;
select means for receiving a first flash clear signal, and driving the common conductive runs with a second flash clear signal so as to force the cells in the columns associated therewith to the first logic state;
a second conductive run disposed in proximity to the common conductive runs; characterised by
interconnection means for interconnecting selected ones of the common conductive runs with the second conductive run; and
in that the select means comprises a plurality of driver circuits distributed along the second conductive run, which operate to simultaneously drive the second flash clear signal onto the second conductive run.

Thus, the present invention as described herein comprises a multiple I/O memory with selectably clearable cells. The memory includes an array of memory cells arranged in rows and columns with each of the rows accessible with a separate row address and each of the columns arranged in predetermined I/O groups and each column associated with a predetermined I/O. The memory cells are operable to force the logic state stored therein to a first logic state in the presence of a clear signal . An externally generated clear signal is selectively input to columns of memory cells associated with a selected I/O. Therefore, only the columns of memory cells associated with a selected I/O are forced to the first logic state in the presence of the clear signal.

Some of the memory cells embodied in a monolithic integrated circuit are grouped together in pairs such that each pair consists of two columns of memory cells each associated with the same I/O and each associated with an adjacent column address. Each of the memory cells has a clear input which is connected to a common first conductive run which is disposed adjacent and parallel to each of the columns of memory cells in the pair. The first conductive runs for the columns of memory cells associated with the selected I/O are connected to a second conductive run disposed adjacent to the array proximate to each of the columns of memory cells. The second conductive run is interfaced with the externally generated clear signal. A driver is provided for driving the distributed capacitance of the first and second conductive runs. Memory cells associated with columns that are not associated with the selected I/O are connected to a source reference voltage instead of to the clear signal; accordingly, the FLASH CLEAR function is not provided for those memory cells.

In the preferred embodiment of the present invention, each of the memory cells is comprised of a static memory cell. The memory cell includes two cross-coupled MOS N-channel transistors having the drains thereof connected to first and second sense nodes, respectively. The source of one of the cross-coupled transistors is connected to a source reference voltage and the source of the second cross-coupled transistor is connected to the clear input. The first and second sense nodes are respectively connected to the drain supply through a pull up device. When the voltage on the clear input is raised to the drain supply voltage, the logic state of the memory cell is forced to a logic "0"; and when the voltage on the clear input is clamped to the source reference voltage, the memory cell operates in a standard manner.

For a more complete understanding of the present invention and the advantages thereof, reference is now made to the following description taken in conjunction with the accompanying Drawings in which:
Figure 1 illustrates a block diagram of an SRAM utilizing the FLASH CLEAR feature of the present invention;
Figure 2 illustrates the architecture of the cell array and the interface with the FLASH CLEAR driver circuitry;
Figure 3 illustrates a schematic diagram of four adjacent columns in the memory array;
Figure 4 illustrates a detailed schematic diagram of one memory cell; and
Figure 5 illustrates a schematic block diagram of a cache memory scheme utilizing the system of the present invention.

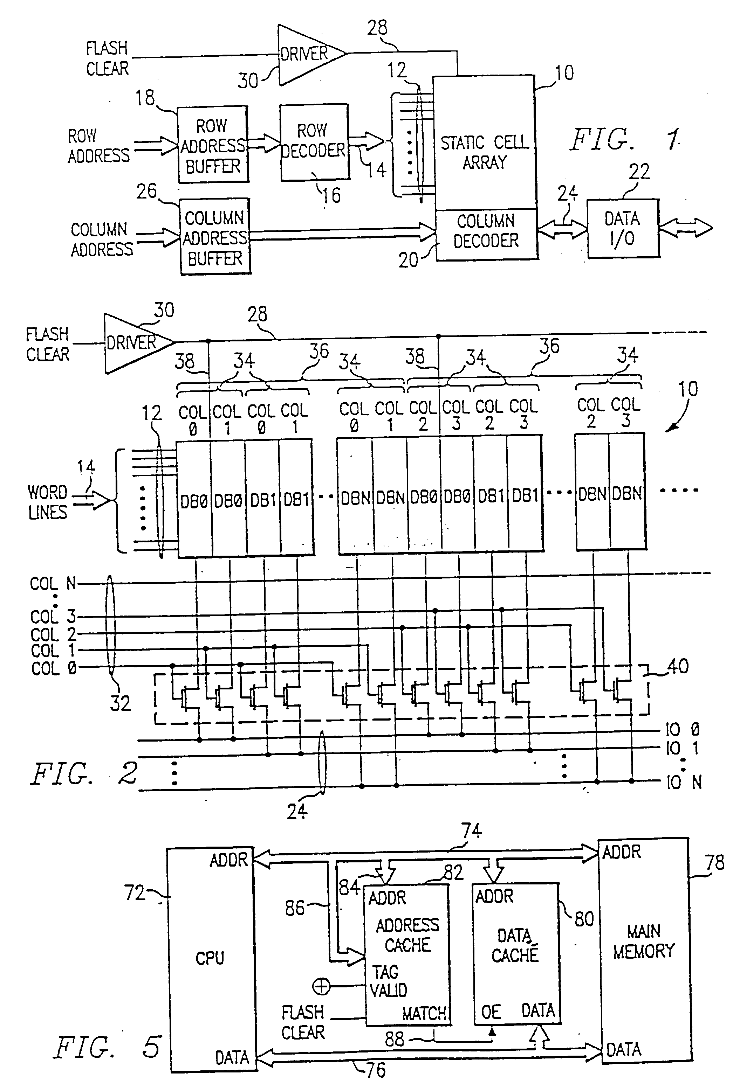

Referring now to Figure 1, there is illustrated a block diagram of an SRAM which may be conveniently fabricated in a monolithic integrated circuit and which utilizes the FLASH CLEAR scheme of the present invention. The memory is comprised of a static cell array 10 which is comprised of a plurality of static memory cells (not shown) arranged in rows and columns. A row of memory cells is selected by activating one of a plurality of Word Lines 12, which are connected to a Word Line bus 14. The Word Line bus 14 is connected to the output of a row decode circuit 16 that is operable to decode a row address which is buffered by a row address buffer 18. The row decode circuit 16 has a mutually exclusive output and selects one of the Word Lines 12 for activation thereof. The memory cells in the row associated with the activated Word Line are then accessed and the contents thereof output on bit lines.

Each of the bit lines in the cell array 10 are connected to a column decode circuit 20 which has the output thereof connected to a data Input/Output (I/O) circuit 22 through a bus 24 which is comprised of a plurality of I/O data lines. The column decode circuit 20 receives a column address from a column address buffer 26. In the preferred embodiment, the column decode circuit 20 is operable to select multiple columns of memory cells for each column address received. Data written to or read from the accessed columns represent an N-bit word. Therefore, the cell array 10 is a "by-N" array.

The cell array 10 has a FLASH CLEAR input associated with a control line 28 which is connected to the output of a driver circuit 30. The driver circuit 30 has the input thereof connected to a FLASH CLEAR control signal. The cell array 10 is operable to preset all memory cells of selected columns of the memory cell array to logic 0's when the FLASH CLEAR signal is input to the driver 30, the selected columns being associated with a common I/O line. By comparison to an arrangement wherein all columns of a memory cell array are necessarily simultaneously flash cleared, the ability to selectively clear any I/O line in the cell array 10 results in lower drive requirements for the driver 30 and a lower associated noise level due to the lower drive current, as will be described in more detail hereinbelow.

Referring now to Figure 2, there is illustrated a partial block diagram of cell array 10 utilizing the flash clearing scheme of the present invention. Typically, columns of memory cells in an integrated circuit are arranged to accommodate various layout considerations, column decoder schemes, etc., such that the columns are not necessarily topologically located in a sequential order relative to their associated I/O line; that is, columns associated with a given column address are not necessarily physically adjacent to each other.

In the preferred embodiment, columns that are associated with a particular one of the data bits DB0̸-DBN are physically grouped together, each of the data bits DB0̸-DBN being associated with a separate I/O line. As will be described hereinbelow, this allows selective clearing of all memory cells associated with a selected data bit. In the preferred embodiment all of the bits DB0̸ are designated as the selected memory cells to be flash cleared. For reasons that will be described hereinbelow, columns associated with the memory cells to be flash cleared for the selected data bit, are physically disposed adjacent to each other in pairs. Each pair represents two adjacent column addresses, for example, Column 0̸ and Column 1. This allows one control line to feed a pair of adjacent columns associated with the memory cells to be cleared.

For example, in the preferred embodiment, the column address COL 0̸ will access memory cells for data bits DB0̸-DBN associated with Column 0̸. In a similar manner, the column address COL 1 will access memory cells for data bits DB0̸-DBN associated with Column 1. The column of memory cells for the DB0̸ data bits associated with the column address COL 0̸ ,and the column of memory cells for the DB0̸ data bits associated with the column address COL 1 are physically disposed adjacent each other with a single control line operative to clear the associated memory cells in response to the FLASH CLEAR signal.

Referring further to Figure 2, the column decoder 20 outputs a plurality of column address lines 32 labelled COL 0̸-COL N. Each of the column address lines 32 is associated with one of N+1 columns and each column address is associated with memory cells for data bits DB0̸-DBN. Therefore, when a row of memory cells is accessed, the presence of the respective column address results in the data bits DB0̸-DBN for the accessed row being output on the data bus 24.

The columns of memory cells are arranged in pairs 34 with each pair 34 representing two adjacent column addresses for a given one of data bits DB0̸-DBN. The pairs 34 are organized in banks 36 with each bank representing all of the columns of memory cells for two adjacent column addresses. For example, in the first bank 36 in the memory array 10, the first pair 34 corresponds to the bits DB0̸ for adjacent column addresses COL 0̸ and COL 1. The next adjacent pair 34 corresponds to the data bits DB1 for adjacent column addresses COL 0̸ and COL 1, with the last pair 34 in the first of the banks 36 corresponding to the data bits DBN for adjacent column addresses COL 0̸ and COL 1. The next adjacent bank 36 corresponds to all of the data bits DB0̸-DBN for adjacent column addresses COL 2 and COL 3, with the last bank 36 representing all of the data bits DB0̸-DBN for adjacent column addresses COL (N-1) and COL N.

Each of the pairs 34 associated with the memory cells for data bits DB0̸ in each of the banks 36 has a control line 38 connected to the FLASH CLEAR control line 28. The line 38 provides an interconnection to the FLASH CLEAR signal through driver 30, which clears all of the memory cells for bits DB0̸ for each bank and for each column address. However, it should be understood that any of the pairs 34 can be connected to the line 28 for the purposes of flash clearing the memory cells associated with that particular data bit. This allows the selection of all of the columns associated with a selected one of data bits DB0̸-DBN to be cleared. Further, for an alternative embodiment, this also allows for selection of a particular column address and memory cells for associated data bits DB0̸-DBN to be cleared. For example, the first bank 36 associated with the column addresses COL 0̸ and COL 1 could be selected such that only the memory cells for the first data bit DB0̸ associated with these two column addresses would be cleared. Although not described herein, this is merely a mask change which requires a jumper to be made from the control line 28, which runs adjacent to the array, to the appropriate terminal in pair 34.

Each of the I/O lines in bus 24 is interconnected to the output of an associated column through one of a plurality of transfer gates 40. Each of the transfer gates comprises an N-channel transistor having a source-to-drain path connected between the respective I/O line and the column output; the gate terminal of each transfer gate is connected to the associated one of the column address lines 32.

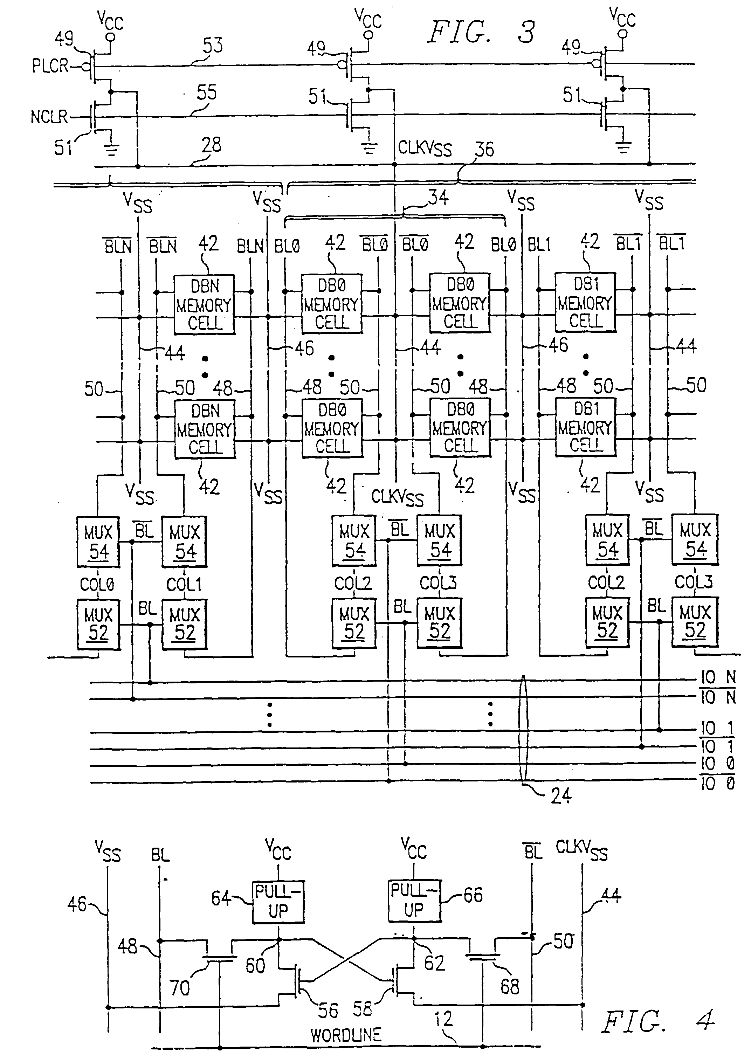

Referring now to Figure 3, there is illustrated a detailed schematic diagram of a portion of the cell array 10 illustrating the interconnections of memory cells 42. The memory cells 42 are arranged in rows and columns such that each memory cell 42 has a specific column and row address location. The wordlines associated with row addresses are not shown. For clarity purposes, the pair 34 in the set associated with the I/O 0̸ line and in the bank 36 associated with the column addresses COL 2 and COL 3 are illustrated. In addition, the column of memory cells 42 associated with both the column address COL 1 and the I/O N line, and the column of memory cells 42 associated with both the column address COL 2 and the I/O 1 line are illustrated.

Each of the memory cells 42 has associated therewith a Bit Line output and a Bit Line-bar output. It should be noted that in any given pair 34, the Bit Line-bar outputs of the associated memory cells 42 are physically located adjacent to one another, whereas the Bit Line outputs are disposed on the opposite sides of the memory cells 42, for reasons that will be described hereinbelow. Each of the memory cells 42 is coupled to two V_{SS} input lines, a V_{SS} input line 44 on the Bit Line-bar side of the memory cell 42 and a V_{SS} input line 46 on the Bit Line side of the memory cell 42.

The V_{SS} input lines 44 for the memory cells 42 in the pair 34 that are associated with the I/O 0̸ line are connected to line 28, which has a signal CLKVSS applied thereto. The remaining memory cells 42 associated with the I/O 1-I/O N lines have the ground reference voltage applied to the V_{SS} input line 44. Each of the V_{SS} input line 46 of all of the memory cells 42 are connected to the ground reference voltage. The CLKVSS signal is utilized to clear the memory cells to which it is coupled. Although the present embodiment only connects the V_{SS} input line 44 of the memory cells 42 associated with the I/O 0̸ line to the control line 28 and the signal CLKVSS, it should be understood that any of the pairs 34 of columns of memory cells 42 could alternately have the V_{SS} inputs 44 thereof selectively connected to the CLKVSS signal to allow FLASH CLEARing of the memory cells in those columns.

Each of the Bit Line outputs of the memory cells 42 is connected to one of a plurality of Bit Lines 48 and each of the Bit Line-bar outputs is connected to one of a plurality of Bit Line-bar lines 50. The Bit Line 48 for each of the columns of memory cells is connected to an associated multiplexer 52 and each of the Bit Line-bar lines 50 is connected to an associated multiplexer 54. The multiplexers 52 and 54 each comprise pass gates similar to the pass gates 40 in Figure 2. Each of the I/O lines in bus 24 has an inverted and a non-inverted form. The inverted form thereof is connected to the output of multiplexer 54 and the non-inverted form is connected to the output of multiplexer 52.

It can be seen from the architecture illustrated in Figure 3 that only one conductive line is required for the CLKVSS signal for a given pair 34 of columns of memory cells. This conductive line is associated with two columns having different column addresses and both columns being associated with the same I/O line, thereby allowing selective flash clearing of all cells associated with a given I/O line without requiring a separate conductive line for the CLKVSS signal to each column of memory cells. By alternating the orientation of the memory cells for a given row such that the Bit Line-bar output of adjacent columns of memory cells 42 are adjacent to each other, it is possible to provide one V_{SS} input line 44 for receiving the CLKVSS signal. All that is required is a memory cell layout having the Bit Line and Bit Line-bar outputs on opposite sides of the cell.

The control line 28 is a conductive run having a distributed capacitance associated therewith and is driven by the driver 30 which comprises a distributed driver. A plurality of CMOS driver circuits are provided, the driver circuits each being represented by a P-channel transistor 49 and an N-channel transistor 51 connected in a complementary configuration between the positive supply V_{CC} and a reference V_{SS} or ground. The drain of the N-channel transistor 51 is connected to the line 28. The CMOS transistor drivers are comprised of transistors 49 and 51 and are distributed along the line 28. In such a manner, a low source impedance can be provided to the line 28. The gates of the P-channel transistors 49 are connected to a control line 53 and the gates of the N-channel transistors 51 are connected to a control line 55 representing the inverted and non-inverted form of the FLASH CLEAR signal and are designated as PLCR and NCLR, respectively. Therefore, the transistors 49 and 51 provide the drive necessary to supply the CLKVSS-signal whereby the voltage of the line 44 connected to the CLKVSS signal can readily be pulled from V_{SS} to V_{CC}. It can be seen that a significantly decreased amount of drive is required to drive only the V_{SS} input lines 44 associated with the I/O 0̸ lines as compared to the amount of drive which would be required to drive all of the cells in the memory array 10.

Referring now to Figure 4, there is illustrated a schematic diagram of one of the static memory cells 42. The memory cell 42 comprises a pair of cross-coupled N-channel transistors 56 and 58. Transistor 56 has the source thereof connected to the V_{SS} input line 46, the drain thereof connected to a sense node 60 and the gate thereof connected to a sense node 62. Transistor 58 has the source thereof connected to the V_{SS} input line 44, the drain thereof connected to the sense node 62 and the gate thereof connected to sense node 60. In the cell 42 illustrated in Figure 4, the V_{SS} input line 44 is connected to the CLKVSS line, and the V_{SS} input line 46, as described above, is connected to V_{SS}, representing a cell that can be flash cleared. However, if the memory cell 42 is not to be flash cleared, the associated V_{SS} input line 44 is connected to V_{SS} rather than to CLKVSS. The source of transistor 58 therefore comprises the FLASH CLEAR input of the memory cell 42.

The sense node 60 is connected to a positive supply V_{CC} through a pull-up transistor 64 and the sense node 62 is connected to the positive supply V_{CC} through a pull-up transistor 66. Node 62 is connected to the Bit-Line-bar 50 through the source-to-drain path of an N-channel access transistor 68, the gate of which is connected to the Word Line 12 for the accessed row. In a similar manner, node 60 is connected to the Bit Line 48 through the source-to-drain path of an N-channel transistor 70, the gate of transistor 70 being connected to Word Line 12. The operation of the memory cell 42 with the V_{SS} input line 44 connected to V_{SS} is identical to a conventional SRAM cell. It should be noted that for the illustrated cell the clear input is on the right side of the cell whereas in the mirrored layout, the cell is mirrored about the center with the clear input on the left side of the cell.

In operation, the memory cell 42 is flash cleared by raising the line 44 from the voltage V_{SS} to the voltage V_{CC}, which operation occurs when the voltages on both line 53 and line 55 go low, thus turning on transistors 49 and turning off transistors 51. When the memory cell 42 is cleared, the non-inverted node 60 is disposed at a low voltage representing a logic "0" and the inverted node 62 is disposed at a high voltage representing a logic "1".

When a logic "1" is stored in the memory cell 42, node 62 is disposed at a low voltage at or near V_{SS}; in this condition transistor 58 is turned on and transistor 56 is turned off. To clear this logic state and force node 62 to a high voltage, the voltage on the source of transistor 58 is pulled to a high voltage such that transistor 58 acts as a source follower and pulls the voltage on node 62 high. This in effect turns on transistor 56, pulling node 60 low, which results in transistor 58 being turned off, such that when the voltage on line 44 is pulled back low, transistor 58 is off and node 62 is high. This provides a clearing operation that does not require any interaction by the row decoder to write logic "0" information from the Bit Lines into the memory cell for the clear operation and, additionally, only minimal power is required.

From a power standpoint, sufficient current is required to overcome the capacitive loading on the drain of transistor 58 from each of the memory cells associated therewith. If all the memory cells 42 in the array 10 were cleared, this would require a high driving current to overcome the capacitive loading, but by clearing only selected I/Os, the capacitive loading and required drive current can be substantially decreased. Further, supplying the CLKVSS signal to all of the memory cells 42 in the array 10 would result in a higher noise level distributed across the memory array 10, and thereby increasing the possibility of an error.

Referring now to Figure 5, there is illustrated a schematic block diagram of a cache memory system illustrating the FLASH CLEAR scheme of the present invention. In the cache memory scheme, a central processing unit (CPU) 72 provides an address output connected to an address bus 74 and a data I/O connected to a data bus 76. The address bus 74 is connected to the address input of a main memory 78, the data input thereof being connected to the data bus 76. The address bus 74 is also input to a data cache 80 with the data input of the data cache 80 connected to the data bus 76. An address cache 82 is also provided which has an address input and a data input, the data input representing the tag information. The address input of the address cache 82 is connected to the three least significant bits of the address through the bus 84. The tag input is connected to the three most significant bits of the address bus 74 through a bus 86. In addition, the address cache 82 has one of the data bits thereof connected to a positive voltage through a pull-up resistor (not shown). The FLASH CLEAR signal is also input to the address cache 82.

The address cache 82 is operable to receive the three least significant bits of the address output by the CPU and to output the addressed location and compare it with the information on the bus 86. If a true comparison is made, a match signal is generated and output on a line 88 to the Output Enable input of the data cache 80. The tag information is stored during a Write operation, which will not be described. When a match is present, this is termed a "hit", which results in the data stored in the data cache 80 being output on the data bus 76. The access time to the data cache as compared to the access time to the main memory 78 is approximately ten times faster, resulting in increased speed.

The FLASH CLEAR input allows the valid bit in the address cache 82 to be cleared without requiring the rest of the memory locations in the address cache 82 to be cleared. As described above, the clearing of selected I/Os removes the requirement for clearing all of the memory locations, thus resulting in lower drive requirements, improved noise levels during clear, etc.

In summary, there has been provided a static random access memory having multiple I/Os with the capability of clearing a selected I/O. The memory is configured such that all columns of memory cells associated with the given I/O can be selectively connected to a clear signal. Further, columns of memory cells for a selected I/O and for two adjacent column addresses are physically disposed adjacent to each other such that they can share a common conductive run disposed parallel to each of the columns and connected to the clear signal. In such a manner, pairs of memory cells associated with the same I/O can be cleared, thus reducing layout constraints.

Although the preferred embodiment has been described in detail, it should be understood that various changes, substitutions and alterations can be made therein without departing from the scope of the invention as defined by the appended claims.

## Claims

1. A memory array with selectively clearable memory cells, comprising:
an array (10) of selectively addressable SRAM cells arranged in rows and columns, including memory cells (42) operable to store first and second logic states therein, and having a flash clear input (28) for forcing the logic state stored therein to the first logic state in response to receiving a flash clear signal at the flash clear input;
a plurality of common conductive runs (38, 44) connected to the flash clear inputs of cells in respective columns;
select means (30) for receiving a first flash clear signal, and driving the common conductive runs with a second flash clear signal so as to force the cells in the columns associated therewith to the first logic state;
a second conductive run (28) disposed in proximity to the common conductive runs; characterised by
interconnection means for interconnecting selected ones of the common conductive runs with the second conductive run; and
in that the select means (30) comprises a plurality of driver circuits (49,51) distributed along the second conductive run, which operate to simultaneously drive the second flash clear signal onto the second conductive run.

2. A memory array according to claim 1 wherein the columns are divided into groups representing a plurality of bit positions (DBO ... DBN).

3. A memory array according to claim 2 which comprises means (26,20) for selecting columns within each group.

4. A memory array according to any preceding claim wherein the common conductive runs are connected to cells in respective pairs of columns wherein the flash clear inputs of the cells in the pair are connected to a shared common conductive run.

5. A memory array according to claim 4 wherein each pair of columns sharing a common conductive run have the same bit position.

6. A memory array according to any preceding claim wherein said interconnection means comprises a conductive interconnect between the ones of said first conductive runs associated with the selected columns and said second conductive run.

7. A memory array according to any preceding claim wherein:
said flash clear signal (CLKVss) has a first state at a first voltage level (Vcc) and a second state at a second voltage level (Vss) and each of said memory cells (42) is operable to force the logic state stored therein to said first logic state when said first voltage level is applied to the flash clear input thereof, and said memory cells not having the logic state thereof altered when said second voltage level is applied to the flash clear input thereof; and
said driver circuits (49,51) are operable to apply said first voltage level (Vcc) to the flash clear inputs of said memory cells in selected columns and said second voltage level (Vss) to the flash clear inputs of said memory cells in unselected columns when said flash clear signal is present.

8. A memory array of any preceding claim, wherein said first and second conductive runs have a distributed capacitance associated therewith.

9. A memory array according to any preceding claim, wherein each of said memory cells comprises:
a first sense node (60);
a second sense node (62);
a first transistor (56) having a source-to-drain path connected between said first sense node (60) and a node providing a second voltage level (Vss) and the gate thereof connected to said second sense node (62);
a second transistor (58) having a source-to-drain path thereof connected between said second sense node (62) and the flash clear input and the gate thereof connected to said first sense node (60); r
first pull up means (64) connected between said first sense node (60) and a power supply (Vcc) for pulling said first sense node to the voltage of said power supply when said first transistor is not conducting;
second pull up means (66) connected between said second sense node (62) and said power supply (Vcc) for pulling said second sense node to the voltage of said power supply when said first transistor is not conducting;
an access transistor (70) having the source-to-drain path thereof connected between said first sense node and column address decode means (20) and the gate thereof connected to row address decode means (16,18); and
said first sense node forced to a voltage level corresponding to a first logic state when the flash clear input is raised to a first voltage level (Vcc).

10. A memory array according to any preceding claim comprising row address decode means (16,18) for receiving and decoding an external row address and accessing the associated one of said rows of memory cells.

11. A memory array according to any preceding claim comprising I/O means for interfacing with the accessed ones of said memory cells for inputting data thereto for a Write operation and outputting data therefrom for a Read operation.

12. A memory array according to any preceding claim wherein each driver circuit comprises a driver transistor (49) having an input connected to receive the flash clear signal and an output operable to drive said common conductive run.

## Patentansprüche

1. Speicheranordnung mit wahlweise bzw. ausgewählt löschbaren Speicherzellen, die aufweist:
eine Anordnung (10) von wahlweise bzw. auswählbar adressierbaren SRAM-Zellen, die in Zeilen und Spalten angeordnet sind, die Speicherzellen (42) enthält, die betreibbar sind, um erste und zweite logische Zustände darin zu speichern und die einen Blitz- bzw. Parallellöscheingang (28) haben, um den darin gespeicherten logischen Zustand in Reaktion auf den Empfang eines Blitz- bzw. Parallellöschsignals an dem Blitz- bzw. Parallellöscheingang in den ersten logischen Zustand zu zwingen;
mehrere gemeinsame leitende Leitungen bzw. Leitungsabschnitte (38, 44), die an die Blitz- bzw. Parallellöscheingänge der Zellen in jeweiligen Spalten angeschlossen sind;
Auswählmittel (30), um ein erstes Blitz- bzw. Parallellöschsignal zu empfangen, und die gemeinsamen leitenden Leitungen bzw. Leitungsabschnitte mit einem zweiten Schnell- bzw. Parallellöschsignal zu betreiben, um so die Zellen in den Spalten, die damit verknüpft sind, in den ersten logischen Zustand zu zwingen;
eine zweite leitende Leitung bzw. Leitungsabschnitt (28), der in Annäherung zu den gemeinsamen leitenden Leitungen bzw. Leitungsabschnitten angeordnet ist; gekennzeichnet durch
Zwischenverbindungsmittel, um eine Zwischenverbindung der allgemeinen leitenden Leitungen bzw. Leitungsabschnitte mit der zweiten leitenden Leitung herzustellen; und
indem die Auswählmittel (30) mehrere Treiberschaltungen (49, 51) aufweisen, die entlang der zweiten leitenden Leitung bzw. Leitungsabschnitt verteilt sind, die tätig sind, um das zweite Blitz- bzw. Parallellöschsignal gleichzeitig an die zweite leitende Leitung bzw. Leitungsabschnitt anzulegen.

2. Speicheranordnung nach Anspruch 1, in der die Spalten in Gruppen aufgeteilt sind, die mehrere Bitpositionen bzw. -stellungen (DB0 ... DBN) darstellen.

3. Speicheranordnung gemäß Anspruch 2. die Mittel (26, 20) aufweist, um Spalten innerhalb jeder Gruppe auszuwählen.

4. Speicheranordnung nach einem der voranstehenden Ansprüche, in der die gemeinsamen leitenden Leitungen bzw. Leitungsabschnitte an Zellen in jeweiligen Paaren von Spalten angeschlossen sind, wobei die Blitz- bzw. Parallellöscheingänge der Zellen in dem Paar an eine geteilte gemeinsame leitende Leitung bzw. Leitungsabschnitt angeschlossen sind.

5. Speicheranordnung nach Anspruch 4, in der jedes Paar von Spalten, die eine gemeinsame leitende Leitung bzw. Leitungsabschnitt teilen, die gleiche Bitposition bzw. -stellung haben.

6. Speicheranordnung nach einem der voranstehenden Ansprüche, in der die Zwischenverbindungsmittel eine leitende Zwischenverbindung zwischen denjenigen der ersten leitenden Leitungen bzw. Leitungsabschnitte, die mit den ausgewählten Spalten verknüpft sind, und der zweiten leitenden Leitung bzw. Leitungsabschnitt aufweisen.

7. Speicheranordnung nach einem der voranstehenden Ansprüche, in der:
das Blitz- bzw. Parallellöschsignal (CLKVss) einen ersten Zustand bei einem ersten Spannungspegel (Vcc) und einen zweiten Zustand bei einem zweiten Spannungspegel (Vss) hat, und jede der Speicherzellen (42) betreibbar ist, um den logischen Zustand, der darin gespeichert ist, in den ersten logischen Zustand zu zwingen, wenn der erste Spannungspegel an dessen Blitz- bzw. Parallellöscheingang angelegt wird, und die Speicherzellen, die nicht deren logischen Zustand haben, geändert werden, wenn der zweite Spannungspegel an deren Blitz- bzw. Parallellöscheingang angelegt wird; und
die Treiberschaltungen (49, 51) sind betreibbar, um den ersten Spannungspegel (Vcc) an die Schnell- bzw. Parallellöscheingänge der Speicherzellen in ausgewählten Spalten und die zweiten Spannungspegel (Vss) an die Blitz- bzw. Parallellöscheingänge der Speicherzellen in nicht ausgewählten Spalten anzulegen, wenn das Blitz- bzw. Parallellöschsignal zugegen ist.

8. Speicheranordnung nach einem der voranstehenden Ansprüche, in der die ersten und zweiten leitenden Leitungen bzw. Leitungsabschnitte eine verteilte Kapazitanz haben, die mit diesen verknüpft ist.

9. Speicheranordnung nach einem der voranstehenden Ansprüche, in der jede der Speicherzellen aufweist:
einen ersten Lese- bzw. Fühlknoten (60);
einen zweiten Lese- bzw. Fühlknoten (62);
einen ersten Transistor (56), der mit einem Source-Drain-Weg zwischen dem ersten Lese- bzw. Fühlknoten (60) und einem Knoten angeschlossen ist, der einen zweiten Spannungspegel (Vss) bereitstellt, und dessen Gate an den zweiten Lese- bzw. Fühlknoten (62) angeschlossen ist;
einen zweiten Transistor (58), der mit seinem Source-Drain-Pfad zwischen dem zweiten Lese- bzw. Fühlknoten (62) und dem Blitz- bzw. Parallellöscheingang angeschlossen ist, und dessen Gate an den ersten Lese- bzw. Fühlknoten (60) angeschlossen ist;
erste Anlaufmittel (64), die zwischen dem ersten Lese- bzw. Fühlknoten (60) und einer Leistungszufuhr (Vcc) angeschlossen sind, um den ersten Lese- bzw. Fühlknoten auf die Spannung der Leistungszufuhr zu ziehen, wenn der erste Transistor nicht leitend ist;
zweite Anlaufmittel (66), die zwischen dem zweiten Lese- bzw. Fühlknoten (62) und der Leistungszufuhr (Vcc) angeschlossen sind, um den zweiten Lese- bzw. Fühlknoten auf die Spannung der Leistungszufuhr zu ziehen, wenn der erste Transistor nicht leitend ist;
einen Zugriffstransistor (70), der mit seinem Source-Drain-Weg zwischen dem ersten Lese- bzw. Fühlknoten und Spaltenadressdekodermitteln (20) angeschlossen ist, und dessen Gate an Zeilenadressdekodermittel (16, 18) angeschlossen ist; und
wobei der erste Lese- bzw. Fühlknoten auf einen Spannungspegel gezwungen wird, der einem ersten logischen Zustand entspricht, wenn der Blitz- bzw. Parallellöscheingang auf einen ersten Spannungspegel (Vcc) angehoben wird.

10. Speicheranordnung nach einem der voranstehenden Ansprüche, die Zeilenadressdekodermittel (16, 18) aufweist, um eine externe Zeilenadresse zu empfangen und zu dekodieren und auf die eine verbundene bzw. verknüpfte der Zeilen von Speicherzellen zuzugreifen.

11. Speicheranordnung nach einem der voranstehenden Ansprüche, die E/A-Mittel aufweist, um eine Schnittstelle mit den Zugegriffenen einen der Speicherzellen einzurichten, um diese Daten für eine Schreiboperation einzugeben und davon Daten für eine Leseoperation auszugeben.

12. Speicheranordnung nach einem der voranstehenden Ansprüche, bei der jede Treiberschaltung einen Treibertransistor (49) aufweist, der einen Eingang, der angeschlossen ist, um das Blitz- bzw. Parallellöschsignal zu empfangen, und einen Ausgang hat, der betreibbar ist, um die gemeinsame leitende Leitung bzw. Leitungsabschnitt zu betreiben.

## Revendications

1. Matrice mémoire munie de cellules de mémoire pouvant être effacées de manière sélective, comprenant :
une matrice (10) de cellules de SRAM pouvant être adressées de manière sélective, agencées en rangées et en colonnes, incluant des cellules de mémoire (42) pouvant être mises en oeuvre pour stocker en leur sein des premier et second états logiques, et possédant une ligne d'entrée avec remise simultanée à l'état de départ (28) pour forcer l'état logique stocké en leur sein au premier état logique en réponse à la réception d'un signal de remise simultanée à l'état de départ au niveau de la ligne d'entrée avec une remise simultanée à l'état de départ;
une pluralité de chemins conducteurs communs (38, 44) reliés à la ligne d'entrée avec une remise simultanée à l'état de départ des cellules dans les colonnes respectives ;
des moyens de sélection (30) pour recevoir un premier signal de remise simultanée à l'état de départ et attaquant les chemins conducteurs communs avec un second signal de remise simultanée à l'état de départ de façon à forcer les cellules dans les colonnes associées à ces dernières au premier état logique ;
un second chemin conducteur (28) disposé à proximité des chemins conducteurs communs ; caractérisé par
des moyens d'interconnexion pour interconnecter des chemins sélectionnés parmi les chemins conducteurs communs au second chemin conducteur ; et
en ce que les moyens de sélection (30) comprennent une pluralité de circuits d'attaque (49, 51) répartis le long du second chemin conducteur, lesquels fonctionnent pour attaquer simultanément le second signal de remise simultanée à l'état de départ sur le second chemin conducteur.

2. Matrice mémoire selon la revendication 1, dans laquelle les colonnes sont divisées en groupes représentant une pluralité de positions de bits (DBO, ..., DBN).

3. Matrice mémoire selon la revendication 2, laquelle comprend des moyens (26, 20) pour sélectionner des colonnes à l'intérieur de chaque groupe.

4. Matrice mémoire selon l'une quelconque des revendications précédentes, dans laquelle les chemins conducteurs communs sont reliés à des cellules dans des couples respectifs de colonnes dans lesquelles les lignes d'entrée avec remise simultanée à l'état de départ des cellules dans le couple sont reliées à un chemin conducteur commun partagé.

5. Matrice mémoire selon la revendication 4, dàns laquelle chaque couple de colonnes partageant un chemin conducteur commun a la même position de bit.

6. Matrice mémoire selon l'une quelconque des revendications précédentes, dans laquelle lesdits moyens d'interconnexion comprennent une interconnexion conductrice entre les chemins desdits premiers chemins conducteurs associés aux colonnes sélectionnées et audit second chemin conducteur.

7. Matrice mémoire selon l'une quelconque des revendications précédentes, dans laquelle :
ledit signal de remise simultanée à l'état de départ (CLKVss) a un premier état à un premier niveau de tension (Vcc) et un second état à un second niveau de tension (Vss), et chacune desdites cellules de mémoire (42) peut être mise en oeuvre pour forcer l'état logique stocké en son sein audit premier état logique lorsque ledit premier niveau de tension est appliqué à la ligne d'entrée avec remise simultanée à l'état de départ de cette dernière, et lesdites cellules de mémoire n'ayant pas l'état logique de cette dernière, modifié lorsque ledit second niveau de tension est appliqué à la ligne d'entrée avec remise simultanée à l'état de départ de cette dernière ; et
lesdits circuits d'attaque (49, 51) peuvent être mis en oeuvre pour appliquer ledit premier niveau de tension (Vcc) aux lignes d'entrée avec remise simultanée à l'état de départ desdites cellules de mémoire dans des colonnes sélectionnées, et ledit second niveau de tension (Vss) aux lignes d'entrée avec remise simultanée à l'état de départ desdites cellules de mémoire dans des colonnes non sélectionnées lorsque ledit signal de remise simultanée à l'état de départ est présent.

8. Matrice de mémoire selon l'une quelconque des revendications précédentes, dans laquelle lesdits premier et second chemins conducteurs ont une capacité répartie associée à ces derniers.

9. Matrice mémoire selon l'une quelconque des revendications précédentes, dans laquelle chacune desdites cellules de mémoire comprend :
un premier noeud de détection (60) ;
un second noeud de détection (62) ;
un premier transistor (56) ayant un chemin source-drain relié entre ledit premier noeud de détection (60) et un noeud donnant un second niveau de tension (Vss), et la grille de ce dernier étant reliée audit second noeud de détection (62) ;
un second transistor (58) ayant un chemin source-drain de ce dernier relié entre ledit second noeud de détection (62) et à la ligne d'entrée avec remise simultanée à l'état de départ, et la grille de ce dernier étant reliée audit premier noeud de détection (60) ;
des premiers moyens d'excursion haute (64) reliés entre ledit premier noeud de détection (60) et une source d'alimentation (Vcc) pour amener ledit premier noeud de détection à la tension de ladite source d'alimentation lorsque ledit premier transistor n'est pas conducteur ;
des seconds moyens d'excursion haute (66) reliés entre ledit second noeud de détection (62) et ladite source d'alimentation (Vcc) pour amener ledit second noeud de détection à la tension de ladite source d'alimentation lorsque ledit premier transistor n'est pas conducteur ;
un transistor d'accès (70) ayant le chemin source-drain de ce dernier relié entre ledit premier noeud de détection et les moyens de décodage d'adresse de colonne (20), et la grille de ce dernier étant reliée aux moyens de décodage d'adresse de rangée (16, 18) ; et
ledit premier noeud de détection forcé à un niveau de tension correspondant à un premier état logique lorsque la ligne d'entrée avec remise simultanée à l'état de départ est élevée à un premier niveau de tension (Vcc).

10. Matrice mémoire selon l'une quelconque des revendications précédentes, comprenant des moyens de décodage d'adresse de rangée (16, 18) pour recevoir et décoder une adresse de rangée externe et pour accéder à la rangée associée desdites rangées de cellules de mémoire.

11. Matrice mémoire selon l'une quelconque des revendications précédentes, comprenant des moyens d'entrée/sortie pour s'interfacer avec les cellules d'entrée/sortie pour s'interfacer avec les cellules auxquelles on a eu accès desdites cellules de mémoire pour entrer des données dans ces dernières lors d'une opération d'Ecriture et pour sortir des données de ces dernières lors d'une opération de Lecture.

12. Matrice mémoire selon l'une quelconque des revendications précédentes, dans laquelle chaque circuit d'attaque comprend un transistor d'attaque (49) ayant une entrée reliée pour recevoir le signal de remise simultanée à l'état de départ et une sortie pouvant être mise en oeuvre pour attaquer ledit chemin conducteur commun.
